# EUROPÄISCHE PATENTSCHRIFT

(11) **EP 2 609 619 B1**
(45) Veröffentlichungstag und Bekanntmachung des Hinweises auf die Patenterteilung: **27.05.2020**
(21) Anmeldenummer: 11764566.3
(22) Anmeldetag: 05.10.2011
(51) Int. Cl.: H01L 21/67

(54) **VORRICHTUNG UND VERFAHREN ZUR PROZESSIERUNG VON WAFERN**
DEVICE AND METHOD FOR PROCESSING WAFERS
DISPOSITIF ET PROCÉDÉ DE TRAITEMENT DE TRANCHES

(30) Priorität: 15.10.2010 DE 102010048043
(43) Veröffentlichungstag der Anmeldung: 03.07.2013
(60) Teilanmeldung: 13174234.8
(73) Patentinhaber: EV Group GmbH, 4782 St. Florian am Inn (AT)
(72) Erfinder: LINDNER, Paul, A-4780 Schärding (AT); HANGWEIER, Peter-Oliver, A-4742 Pram (AT)
(74) Vertreter: Schweiger, Johannes
(86) Internationale Anmeldenummer: PCT/EP2011/067405
(87) Internationale Veröffentlichungsnummer: WO 2012/049058

(56) Entgegenhaltungen:
- WO-A1-99/18603
- JP-A- 2010 212 638
- US-A- 5 455 082
- US-A1- 2003 003 767

## Beschreibung

Die Erfindung betrifft eine Vorrichtung zum Bonden von Substratpaaren gemäß Patentanspruch 1.

Die US 5,395,474 betrifft eine Vorrichtung und ein Verfahren zum Ätzen eines Wafers. Die US 4,764,076 betrifft ein Ventil für eine Waferverarbeitungsvorrichtung. Die US 5,044,871 betrifft ein integral ausgebildetes Wafertransportsystem zur Verarbeitung von Schaltkreisen. Die US 4,388,034 betrifft eine Vorrichtung zum Verarbeiten von Substraten in Kammern.

Als nächstliegender Stand der Technik offenbart die JP 2010 212638 A eine Vorrichtung und ein Verfahren zum Herstellen eines Halbleiterproduktes mit einer Vorkammer, einer Bondkammer sowie einem Nachbehandlungsraum, wobei die Vorkammer mit der Bondkammer durch ein Ventil verbunden sind. Prozessanlagen beziehungsweise -vorrichtungen der Halbleitertechnologie sind meist modular aufgebaut. Sie bestehen üblicherweise aus unterschiedlichen Kammern, in denen verschiedene Prozessschritte durchgeführt werden. So kommen beispielsweise zur Vorbehandlung von Wafern Prozessschritte wie Nassreinigung, Plasmabehandlung, Ätzen oder Heizen in Frage, während für die Hauptbehandlung eines Wafers Bonden, Belacken, Imprinten, Embossing und Belichtung in Frage kommen. Bei bekannten Prozessanlagen werden die Wafer oder Waferstapel mit Kassetten zwischen den Prozessanlagen oder Modulen von Prozessanlagen transportiert. Während des Transports kann es zur Kontamination, Beschädigung, Verunreinigung oder Oxidation und damit zur Beeinflussung weiterer Prozessschritte kommen.

Auch eine Kontamination der Hauptbehandlungskammer zwischen den Behandlungen aufeinanderfolgender Wafer, also beim Be- und Entladen der Wafer, ist problematisch.

Weiterhin ist es in zeitlicher Hinsicht kritisch, dass bei der Hauptbehandlung große Druckdifferenzen von Atmosphärendruck bis hin zu sehr niedrigeren Drücken von 10⁻⁶ bar oder weniger überwunden werden müssen.

Aufgabe der vorliegenden Erfindung ist es daher, die Prozessierung von Substraten sowohl vom Ablauf her zu optimieren, als auch eine Kontamination, Beschädigung, Verunreinigung oder Oxidation möglichst zu vermeiden.

Diese Aufgabe wird mit den Merkmalen des Patentanspruchs 1 gelöst. Vorteilhafte Weiterbildungen der Erfindung sind in den Unteransprüchen angegeben.

Der Erfindung liegt der Gedanke zu Grunde, ein Hauptbehandlungsmodul mit mindestens zwei Vorbehandlungsmodulen und mindestens einem Nachbehandlungsmodul derart zu koppeln, dass mindestens eines der Vorbehandlungsmodule und mindestens eines der Nachbehandlungsmodule und/oder das Hauptbehandlungsmodul jeweils als vakuumdichte Schleusen für ein benachbartes Vorbehandlungs-, Hauptbehandlungs- oder Nachbehandlungsmodul wirken. Gleichzeitig ist es erfindungsgemäß in einer Ausführungsform der Erfindung vorgesehen, dass mindestens eines der Vorbehandlungsmodule und/oder das Hauptbehandlungsmodul und/oder mindestens eines der Nachbehandlungsmodule eigenständig beziehungsweise unabhängig von einem benachbarten Modul mit Druck, Vakuum insbesondere, beaufschlagbar und/oder temperierbar, insbesondere beheizbar, ist.

Auf diese Weise wird trotz eines flexiblen Aufbaus der Prozessanlage gemäß der erfindungsgemäßen Vorrichtung eine zeitlich optimierte, sogar parallele, Prozessierung von mehreren Substraten innerhalb der erfindungsgemäßen Vorrichtung vorgesehen, bei der auf Grund der schleusenartigen Kupplung der einzelnen Prozessmodule eine Kontamination, Beschädigung, Verunreinigung oder Oxidation durch Entkopplung der Substrate von Außeneinflüssen, insbesondere beim Be- und Entladen der einzelnen Module, gelöst wird.

Besonders vorteilhaft ist es, wenn das Hauptbehandlungsmodul ausschließlich über Schleusen be- und entladbar ist. Dies wird erfindungsgemäß gelöst, indem sowohl ein mit dem Hauptbehandlungsmodul schleusenartig gekoppeltes Vorbehandlungsmodul als auch ein mit dem Hauptbehandlungsmodul schleusenartig gekoppeltes Nachbehandlungsmodul vorgesehen ist. Durch diese Maßnahme findet die meist besonders kritische und unter oft extremen Bedingungen stattfindende Hauptbehandlung der Substrate beziehungsweise Wafer zu keinem Zeitpunkt der Prozessierung und auch nicht während des Be- und Entladens des Hauptbehandlungsmoduls mit Kontakt zur Umgebung statt. Das Hauptbehandlungsmodul ist demnach vollständig von der Umgebung entkoppelt, so dass eine Kontamination, Beschädigung, Verunreinigung oder Oxidation während der Hauptbehandlung der Substrate praktisch ausgeschlossen ist. Weiterhin besteht der Vorteil, dass die Hauptbehandlung vor- und nachbereitende Schritte in das Vorbehandlungs- und das Nachbehandlungsmodul ausgelagert werden können, insbesondere eine zumindest teilweise Druck- und/oder Temperaturbeaufschlagung. Im Hauptbehandlungsmodul ist in Folge dessen nur eine geringere Druck- und/oder Temperaturdifferenz zu überwinden als vom Umgebungs-/Atmosphärendruck p_{ATM}.

Gemäß einer vorteilhaften Ausführungsform der Erfindung ist vorgesehen, dass die Hauptbehandlungskammer beim Be- und Entladen der Substrate als Schleuse schaltbar ist. Somit kann beim Beladen der Hauptbehandlungskammer gleichzeitig eine Nachbehandlung des vorher in der Hauptbehandlungskammer bearbeiteten Substrats erfolgen. Beim Entladen der Hauptbehandlungskammer kann dagegen gleichzeitig eine Vorbehandlung des nächsten, in der Hauptbehandlungskammer zu bearbeitenden Substrats in der Vorbehandlungskammer erfolgen.

In einer weiteren, vorteilhaften Ausführungsform ist vorgesehen, dass die Vorbehandlungskammer und/oder die Hauptbehandlungskammer und/oder die Nachbehandlungskammer, insbesondere separat, mittels einer Heizeinrichtung heizbar sind. Besonders vorteilhaft ist es dabei, wenn die Vorbehandlungskammer und/oder die Hauptbehandlungskammer und/oder die Nachbehandlungskammer vollständig wärmegedämmt sind. Auf diese Weise ist eine genaue Temperatursteuerung bei geringst möglichem Wärmeverlust möglich.

Soweit den Vorbehandlungsmodulen weitere, korrespondierend ausgebildete Vorbehandlungsmodule als Schleusen vorschaltbar sind und/oder dem Nachbehandlungsmodul weitere, korrespondierend ausgebildete Nachbehandlungsmodule als Schleusen nachschaltbar sind, kann der Verfahrensablauf weiter unterteilt werden, so dass sich eine Optimierung der Durchlaufzeiten im Prozessablauf ergibt. Dabei ist es erfindungsgemäß denkbar, dass mit einem Vorbehandlungsmodul gleichzeitig mehrere Vorbehandlungsmodule über Schleusentore direkt gekoppelt sind. Auf diese Weise können zeitintensive Vorbehandlungsschritte parallel und entsprechend zeitversetzt in den vorgeschalteten Vorbehandlungsmodulen ablaufen. Dies gilt analog für korrespondierende Nachbehandlungsmodule. Indem die Schleusen als Druck- und/oder Temperaturschleusen ausgebildet sind, ist es erfindungsgemäß möglich, den Druck und/oder die Temperatur durch entsprechende Schaltung der Vorbehandlungsmodule und/oder der Nachbehandlungsmodule zu steuern.

Zum Be- und Entladen ist erfindungsgemäß eine Be- und Entladeeinrichtung, insbesondere mindestens ein Roboterarm, vorgesehen. Dieser wird zum Be- und Entladen der Substrate in die/aus der Hauptbehandlungskammer und/oder der Vorbehandlungskammer und/oder der Nachbehandlungskammer eingesetzt, wobei zur parallelen Handhabung mehrere, im Prozessablauf befindliche Substrate/Wafer erfindungsgemäß mehrere Roboterarme vorgesehen sein können. So kann beispielsweise in jeder Vorbehandlungskammer und/oder jeder Nachbehandlungskammer genau ein Roboterarm vorgesehen sein, der in die jeweils benachbarte Vorbehandlungs- oder Hauptbehandlungskammer zu Be- und Entladen der jeweils benachbarten Kammern eingreifen kann, wenn das jeweilige Schleusentor geöffnet ist. Gemäß einer besonders vorteilhaften Ausführungsform der Erfindung ist vorgesehen, dass die Hauptbehandlungskammer gleichzeitig von der Vorbehandlungskammer be- und in die Nachbehandlungskammer entladbar ist und/oder die Vorbehandlungskammer und die Nachbehandlungskammer gleichzeitig über das erste Schleusentor be- und über das zweite Schleusentor entladbar sind.

Weitere Vorteile, Merkmale und Einzelheiten der Erfindung ergeben sich aus der nachfolgenden Beschreibung bevorzugter Ausführungsbeispiele sowie anhand der Zeichnungen; diese zeigen in:
- Fig. 1a: eine schematische Aufsicht auf eine Vorrichtung mit einem Vorbehandlungsmodul, einem Hauptbehandlungsmodul und einem Nachbehandlungsmodul,
- Fig. 1b: eine schematische Schnittansicht der Vorrichtung gemäß Schnittlinie A-A aus Figur 1a,
- Fig. 2a: eine schematische Aufsicht auf eine zweite Ausführungsform der Vorrichtung mit einem Vorbehandlungsmodul, einem Hauptbehandlungsmodul und einem Nachbehandlungsmodul,
- Fig. 2b: eine schematische Schnittansicht der Vorrichtung gemäß Schnittlinie A-A aus Figur 2a,
- Fig. 2c: eine schematische Schnittansicht der Vorrichtung gemäß Schnittlinie B-B aus Figur 2a,
- Fig. 3: ein Druck-/Temperaturdiagramm eines erfindungsgemäßen Verfahrens zur Prozessierung von Substraten und
- Fig. 4: eine Schnittansicht der Vorrichtung mit einem Vorbehandlungsmodul, einem Hauptbehandlungsmodul und einem Nachbehandlungsmodul.

In den Figuren sind gleiche Bezugszeichen für korrespondierende Bauteile vorgesehen.

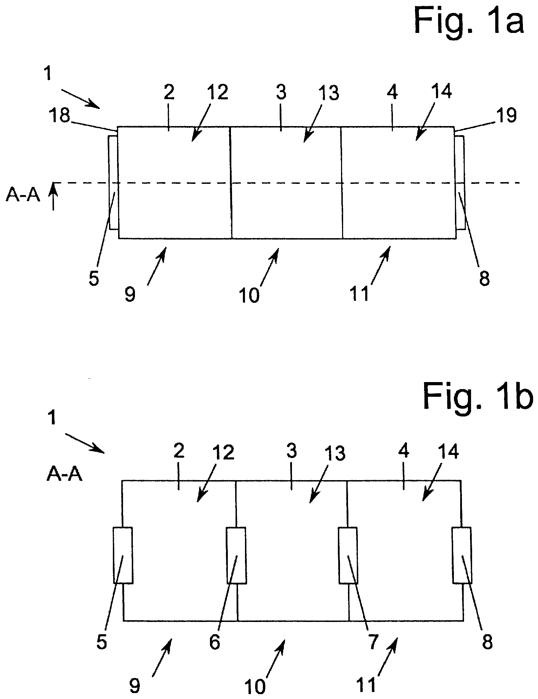

In der in Figur 1 gezeigten Ausführungsform einer Vorrichtung 1 sind ein Vorbehandlungsmodul 9, ein Hauptbehandlungsmodul 10 und ein Nachbehandlungsmodul 11 linear in Reihe angeordnet.

Das Vorbehandlungsmodul 9 besteht aus einer mit Vakuum beaufschlagbaren Vorbehandlungskammer 2, die einen Vorbehandlungsraum 12 umschließt. An die Vorbehandlungskammer 2 ist eine nicht dargestellte Druckbeaufschlagungseinrichtung angeschlossen, die von einer nicht dargestellten zentralen Steuereinrichtung steuerbar ist, um den Druck in dem Vorbehandlungsraum 12 bei geschlossener Vorbehandlungskammer 2 steuern zu können. Über eine nicht dargestellte Temperaturbeaufschlagungseinrichtung ist der Vorbehandlungsraum 12 heizbar und/oder kühlbar, wobei die Temperaturbeaufschlagungseinrichtung von der zentralen Steuereinrichtung steuerbar ist.

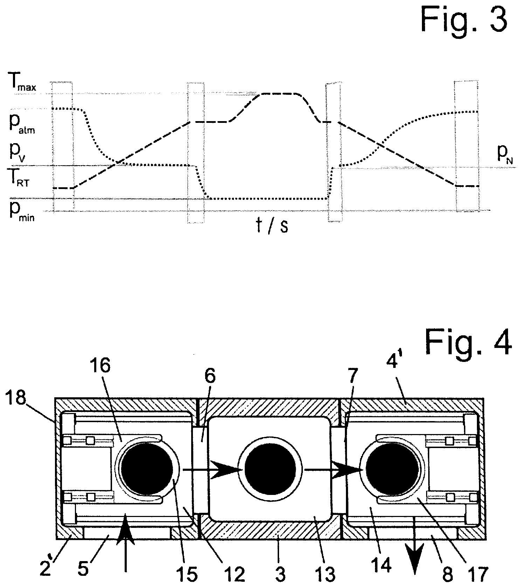

Zum Beladen des Vorbehandlungsmoduls 9 mit einem (oder mehreren) Wafer 15 ist gemäß Figur 4 ein erster Roboterarm 16 vorgesehen. Dieser ist - gesteuert von der zentralen Steuereinrichtung - durch ein erstes Schleusentor 5 hindurchführbar, wenn das erste Schleusentor 5 geöffnet ist. Das Öffnen und Schließen des ersten Schleusentors 5 wird ebenfalls durch die zentrale Steuereinrichtung gesteuert.

Das erste Schleusentor 5 ist in der Ausführungsform gemäß Figur 1a und 1b an einer ersten Stirnseite 18 der Vorrichtung 1 angeordnet. Das erste Schleusentor 5 ist druckdicht verschließbar und weist eine Wärmedämmung auf, damit der Vorbehandlungsraum 12 im geschlossenen Zustand des ersten Schleusentors 5 unter Druck gesetzt werden kann.

Weiterhin weist die Vorbehandlungskammer 2 gegenüberliegend zum ersten Schleusentor 5 gemeinsam mit einer Hauptbehandlungskammer 3 des Hauptbehandlungsmoduls 10 ein erstes Hauptschleusentor 6 auf. Das erste Hauptschleusentor 6 ist funktional analog dem ersten Schleusentor 5 ausgebildet. Das Hauptbehandlungsmodul 10 ist am ersten Hauptschleusentor 6 mit dem Vorbehandlungsmodul 9 druckdicht koppelbar, wodurch ein modulartiger Aufbau und ein Austausch einzelner Module 9, 10, 11 der Vorrichtung 1 realisierbar sind.

Durch Steuerung des ersten Schleusentors 5 und des ersten Hauptschleusentors 6 mittels der zentralen Steuereinrichtung ist das Vorbehandlungsmodul 9 als Schleuse einsetzbar, nämlich indem bei geöffnetem ersten Schleusentor 6 das erste Schleusentor 5 geschlossen ist und umgekehrt.

Das Hauptbehandlungsmodul 10 besteht aus der Hauptbehandlungskammer 3, die einen Hauptbehandlungsraum 13 umschließt beziehungsweise bildet.

Gegenüberliegend zum ersten Hauptschleusentor 6 der Hauptbehandlungskammer 3 ist ein zumindest teilweise zur Hauptbehandlungskammer 3 zählendes zweites Hauptschleusentor 7 vorgesehen, das zum Entladen des Wafers 15 von der Hauptbehandlungskammer 3 in eine Nachbehandlungskammer 4 dient. Das zweite Hauptschleusentor 7 ist zumindest teilweise von der Nachbehandlungskammer 4 gebildet. Der Hauptbehandlungsraum 13 ist durch das zweite Hauptschleusentor 7 von einem Nachbehandlungsraum 14 der Nachbehandlungskammer 4 druckdicht abdichtbar. Funktional entspricht das zweite Hauptschleusentor 7 dem ersten Hauptschleusentor 6, wobei das erste Hauptschleusentor 6 und das zweite Hauptschleusentor 7, gesteuert von der zentralen Steuereinrichtung, eine Schleuse bilden.

Das Nachbehandlungsmodul 11 zur Nachbehandlung des Wafers 15 nach der Hauptbehandlung in dem Hauptbehandlungsmodul 10 besteht aus der Nachbehandlungskammer 4, die den Nachbehandlungsraum 14 bildet. Weiterhin weist die Nachbehandlungskammer 4 ein zweites Schleusentor 8 auf, das dem zweiten Hauptschleusentor 7 gegenüberliegend angeordnet ist.

Über das zweite Schleusentor 8 und mittels eines zweiten Roboterarms 17 kann der Wafer 15 nach der Nachbehandlung aus dem Nachbehandlungsraum 14 entladen werden, sobald das zweite Schleusentor 8 geöffnet ist.

Das Nachbehandlungsmodul 11 kann ebenfalls als Schleuse wirken, indem das zweite Hauptschleusentor 7 geschlossen ist, wenn das zweite Schleusentor 8 geöffnet ist und umgekehrt.

Das zweite Schleusentor 8 ist an einer zweiten Stirnseite 19 der Vorrichtung 1 angeordnet, so dass eine lineare Bewegung des Wafers 15 während des gesamten Prozessablaufs durch das Vorbehandlungsmodul 9, das Hauptbehandlungsmodul 10 und das Nachbehandlungsmodul 11 hindurch erfolgt.

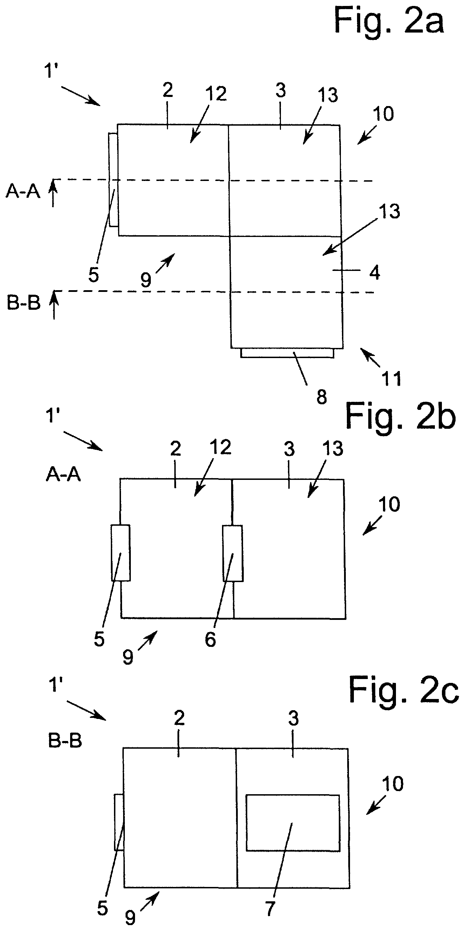

Die Ausführungsform gemäß Figur 2a unterscheidet sich durch winkelige Anordnung der Module 9, 10, 11, so dass sich eine geänderte Vorrichtung 1' ergibt. Geändert ist lediglich die Ausgestaltung der Hauptbehandlungskammer 3', da das zweite Hauptschleusentor 7 nicht gegenüberliegend zum ersten Hauptschleusentor 6 angeordnet ist, sondern an einer Seitenwand der Hauptbehandlungskammer 3'.

In einer weiteren Ausführungsform der Erfindung könnte in der Ausführungsform gemäß Figuren 1a und 1b ein zusätzliches Seitenmodul (nicht dargestellt) analog dem Nachbehandlungsmodul 11 in Figur 2a seitlich am Hauptbehandlungsmodul 10 angeordnet sein, um beschädigte Wafer, die während des Prozessflusses erkannt werden, aus dem Prozessablauf zu entfernen.

Ein erfindungsgemäßer Verfahrensablauf, dessen Druck- und Temperaturverlauf in Figur 3 dargestellt ist, läuft wie folgt ab:
Das erste Hauptschleusentor 6 und das zweite Hauptschleusentor 7 werden geschlossen. Danach wird der Druck im Hauptbehandlungsraum 13 durch eine nicht dargestellte Druckbeaufschlagungseinrichtung, beispielsweise eine Vakuumpumpe, abgesenkt, insbesondere auf einem Druck pₘᵢₙ kleiner 10⁻⁶ bar, vorzugsweise auf einen Druck kleiner 10⁻⁹ bar. Dies erfolgt idealerweise nur ein einziges Mal während der Prozessierung von einer Vielzahl, insbesondere mehr als 100, vorzugsweise mehr als 1000, noch bevorzugter mehr als 10000 Wafern oder Waferpaaren.

Über das geöffnete erste Schleusentor 5 wird ein Wafer 15 oder Waferpaar mittels des ersten Roboterarms 16 in die Vorbehandlungskammer geladen und dort behandelt. Bei der Vorbehandlung kann es sich um einen trockenen und/oder nassen Prozessschritt handeln, beispielsweise Nassreinigung, Plasmabehandlung, Ätzen, Heißen oder ähnliches. Besonders vorteilhaft umfasst die Vorbehandlung eine, insbesondere optische und/oder mechanische Ausrichtungseinrichtung.

Vor oder nach beziehungsweise während des Vorbehandlungsschritts kann der Vorbehandlungsraum 12 über eine separat ansteuerbare Druckbeaufschlagungseinrichtung evakuiert werden.

Vor dem Öffnen des ersten Hauptschleusentors 6 wird jedenfalls das erste Schleusentor 5 geschlossen und der Vorbehandlungsraum 12 evakuiert, insbesondere auf einem Druck pᵥ beim oder kurz vor dem Beladen der Hauptbehandlungskammer 3 von weniger als 10⁻⁶ bar, vorzugsweise weniger als 10⁻⁷ bar, so dass das Vorbehandlungsmodul 9 als Schleuse für das Hauptbehandlungsmodul 10 wirkt.

Durch ein internes Transportsystem, beispielsweise einen Roboterarm, wird der Wafer 15 durch das erste Hauptschleusentor 6 hindurch in die Hauptbehandlungskammer 3, 3' geladen.

Anschließend wird das erste Hauptschleusentor 6 geschlossen. Während des Beladens der Hauptbehandlungskammer 3, 3' ist das zweite Hauptschleusentor 7 ständig geschlossen. Der Druck wird vorzugsweise weiter abgesenkt auf pₘᵢₙ kleiner 10⁻⁶ bar, noch bevorzugter 10⁻⁹ bar.

Nach dem Schließen des ersten Hauptschleusentors 6 kann bereits ein weiterer Wafer 15 in die Vorbehandlungskammer 2 geladen werden. Gleichzeitig findet die Hauptbehandlung des ersten Wafers 15 im Hauptbehandlungsmodul 10 statt. Hierbei kann es sich beispielsweise um Bonden, Belacken, Imprinten, Embossing oder eine Belichtung handeln. Nach der Hauptbehandlung des Wafers 15 im Hauptbehandlungsmodul 10 wird der Wafer 15 durch Öffnen des zweiten Hauptschleusentors 7 in das Nachbehandlungsmodul 11 geladen, wobei das zweite Schleusentor 8 geschlossen ist. Vor dem Öffnen des zweiten Hauptschleusentors 7 wird der Nachbehandlungsraum 14 durch eine Druckbeaufschlagungseinrichtung des Nachbehandlungsmoduls 11 mit Vakuum, insbesondere einem Druck p_{N} von weniger als 10⁻⁶, vorzugsweise weniger als 10⁻⁷, beaufschlagt, und zwar zumindest bis der Wafer 15 vom Hauptbehandlungsmodul 10 in das Nachbehandlungsmodul 11 geladen ist und das zweite Hauptschleusentor 7 wieder geschlossen ist.

Anschließend findet eine Nachbehandlung des Wafers 15 im Nachbehandlungsmodul 11 statt, beispielsweise eine Abkühlung und gleichzeitige Erhöhung des Drucks durch die Druckbeaufschlagungseinrichtung des Nachbehandlungsmoduls 11.

Nach Abschluss der Nachbehandlung des Wafers 15 im Nachbehandlungsmodul 11 wird der Wafer 15 über das zweite Schleusentor 8 und den zweiten Roboterarm 17 entnommen.

Vor jedem Öffnen des Hauptschleusentors 6 sind die Vorbehandlungskammer 2 und vor jedem Öffnen des Hauptschleusentors 7 die Nachbehandlungskammer 4 mit einem Druck p_{V} beziehungsweise p_{N} kleiner als der Atmosphären- oder Umgebungsdruck p_{ATM} außerhalb der Kammern 2, 3, 4 beaufschlagt und/oder dekontaminiert, insbesondere mit Inertgas gespült.

Erfindungsgemäß ist der Wafer 15 ein Waferpaar beziehungsweise wird ein Waferpaar mittels einer Halterung beziehungsweise Handhabungseinrichtung zur Handhabung des Waferpaars in die Vorrichtung 1 in der oben beschriebenen Art und Weise geladen, wobei die im linken Abschnitt in Figur 3 dargestellte Vorbehandlung die Schritte Aufheizen, Evakuieren, Gasspülung mit reduzierenden Gasen, eine nasschemische Behandlung, eine Plasmabehandlung und/oder einen Argon-Beschuss umfasst.

Die Hauptbehandlung erfolgt bei einem im Vergleich zur Vorbehandlung höheren Vakuum, also niedrigerem Druck pₘᵢₙ, wie es in Figur 3 im mittleren Abschnitt dargestellt ist. Durch die Druckbeaufschlagungseinrichtung des Hauptbehandlungsmoduls 10 wird dabei eine kontrollierte Gasatmosphäre, also ein genau eingestellter Gasdruck sowie ein genau kontrolliertes Mischungsverhältnis von Gasen eingestellt. Dann wird das Waferpaar in Kontakt gebracht und gebondet. Davor wird die für die Verbindung nötige Temperatur, insbesondere Tₘₐₓ größer als 250°C, vorzugsweise Tₘₐₓ größer als 400 °C, eingestellt. Beim Bonden wird eine möglichst gleichmäßige Kraft auf das Waferpaar aufgebracht und/oder eine elektrische Spannung angelegt. Die Nachbehandlung, die in Figur 3 im rechten Abschnitt dargestellt ist, erfolgt in einer nicht oxidierenden Umgebung, bei der eine Abkühlung erfolgt und eine Anhebung des Drucks auf Atmosphärendruck. Eine langsame Kühlung verhindert oder vermeidet thermische Spannungen im vorher gebondeten Waferpaar.

Die Vorbehandlung des Waferpaars kann erfindungsgemäß derart erfolgen, dass ein erstes Vorbehandlungsmodul für eine Vorbehandlung des ersten Wafers oder Waferpaares und ein zweites Vorbehandlungsmodul für eine Vorbehandlung des zweiten Wafers oder Waferpaars vorgesehen ist. Der erste und der zweite Wafer sind über separate Schleusentore in die Hauptbehandlungskammer ladbar.

Die Kammern 2, 3, 4 sind vorzugsweise aus rostfreiem Stahl oder Aluminium gefertigt.

Bei der in Figur 4 gezeigten Ausführungsform ist das erste Schleusentor 5 nicht an der Stirnseite 18 der Vorbehandlungskammer 2', sondern an der Seitenwand angeordnet. Das zweite Schleusentor 8 ist nicht an der Stirnseite 19, sondern an der Seitenwand der Nachbehandlungskammer 4' angeordnet.

Der Prozessfluss ist durch Pfeile in Figur 4 dargestellt.

Die Hauptschleusentore 6, 7 müssen entsprechend hohe Druckdichtigkeit bis pₘᵢₙ aufweisen und sind vorzugsweise als Transferventil ausgebildet, das in einem gemeinsamen Kanal zwischen den jeweils benachbarten Kammern 2, 3, 4 dichtend eingesetzt beziehungsweise einsetzbar ist. Der Öffnungsdurchmesser der Schleusentore 5, 6, 7, 8 beträgt mehr als 200mm, insbesondere mehr als 300mm, vorzugsweise mehr als 450mm.

### Bezugszeichenliste

- 1, 1': Vorrichtung
- 2, 2': Vorbehandlungskammer
- 3, 3': Hauptbehandlungskammer
- 4, 4': Nachbehandlungskammer
- 5: erstes Schleusentor
- 6: erstes Hauptschleusentor
- 7: zweites Hauptschleusentor
- 8: zweites Schleusentor
- 9: Vorbehandlungsmodul
- 10: Hauptbehandlungsmodul
- 11: Nachbehandlungsmodul
- 12: Vorbehandlungsraum
- 13: Hauptbehandlungsraum
- 14: Nachbehandlungsraum
- 15: Wafer
- 16: erster Roboterarm
- 17: zweiter Roboterarm
- 18: erste Stirnseite
- 19: zweite Stirnseite

## Patentansprüche

1. Vorrichtung zum Bonden von Substratpaaren mit
- einem ersten Vorbehandlungsmodul zur Vorbehandlung eines ersten Substrats eines Substratpaares mit einer einen Vorbehandlungsraum (12) umschließenden, mit Vakuum beaufschlagbaren Vorbehandlungskammer (2) mit einem ersten Schleusentor (5), wobei das erste Vorbehandlungsmodul für eine Vorbehandlung des ersten Substrats des Substratpaares und ein zweites Vorbehandlungsmodul für eine Vorbehandlung eines zweiten Substrats des Substratpaares vorgesehen sind,
- mindestens einem Hauptbehandlungsmodul (10) mit einer einen Hauptbehandlungsraum (13) umschließenden, separat von der Vorbehandlungskammer (2) mit Vakuum beaufschlagbaren Hauptbehandlungskammer (3), in welcher das Substratpaar in Kontakt gebracht und gebondet werden kann, während das erste Vorbehandlungsmodul gleichzeitig mit einem weiteren Substrat eines Substratpaars beladen werden kann,
- einem die Vorbehandlungskammer (2) mit der Hauptbehandlungskammer (3) vakuumdicht verbindenden ersten Hauptschleusentor (6), wobei das erste Vorbehandlungsmodul als Schleuse für die Beladung der Hauptbehandlungskammer (3) mit Substraten schaltbar ist, und wobei das erste und das zweite Substrat über separate Schleusentore in die Hauptbehandlungskammer (3) ladbar sind,
- mindestens einem Nachbehandlungsmodul (11) mit einer einen Nachbehandlungsraum (14) umschließenden, separat von der Hauptbehandlungskammer (3) mit Vakuum beaufschlagbaren Nachbehandlungskammer (4) mit einem zweiten Schleusentor (8) und
- einen die Hauptbehandlungskammer (3) mit der Nachbehandlungskammer (4) vakuumdicht verbindenden zweiten Hauptschleusentor (7), wobei das Nachbehandlungsmodul (11) als Schleuse für die Entladung der Substrate von der Hauptbehandlungskammer (3) schaltbar ist.

2. Vorrichtung nach einem der vorhergehenden Ansprüche, bei der die Hauptschleusentore (6, 7) als, insbesondere in einem gemeinsamen Kanal zwischen dem jeweils benachbarten Kammern (2, 3, 4) dichtend eingesetzte Transferventile ausgebildet sind.

3. Vorrichtung nach einem der vorhergehenden Ansprüche, bei der eine Be- und Entladeeinrichtung, insbesondere mindestens ein Roboterarm (16, 17), zum Be- und Entladen der Substrate in die und aus der Hauptbehandlungskammer (3) und/oder Vorbehandlungskammer (2) und/oder Nachbehandlungskammer (4) vorgesehen ist.

4. Vorrichtung nach einem der vorhergehenden Ansprüche, bei der die Hauptbehandlungskammer (3) gleichzeitig von der Vorbehandlungskammer (2) be- und in die Nachbehandlungskammer (4) entladbar ist und/oder die Vorbehandlungskammer (2) und die Nachbehandlungskammer (4) gleichzeitig über das erste Schleusentor (5) be- und über das zweite Schleusentor (8) entladbar sind.

## Claims

1. A device for bonding substrate pairs, with
- a first pretreatment module for pretreating a first substrate of a substrate pair with a pretreatment chamber (2) which can be exposed to a vacuum and which surrounds a pretreatment space (12), with a first lock door (5), wherein the first pretreatment module for pretreatment of the first substrate of the substrate pair and a second pretreatment module for pretreatment of the second substrate of the substrate pair are provided,
- at least one primary treatment module (10) with a primary treatment chamber (3) which can be exposed to a vacuum separately from the pretreatment chamber (2) and which surrounds a primary treatment space (13), in which the substrate pair can be brought into contact and bonded, while the first pretreatment module can be simultaneously loaded with a further substrate of a substrate pair,
- a first primary lock door (6) which connects the pretreatment chamber (2) to the primary treatment chamber (3) vacuum-tight, the first pretreatment module being switchable as a lock for the loading of the primary treatment chamber (3) with substrates, and wherein the first and the second substrate can be loaded into the primary treatment chamber (3) via separate lock doors,
- at least one aftertreatment module (11) with an aftertreatment chamber (4) which can be exposed to a vacuum separately from the primary treatment chamber (3) and which surrounds an aftertreatment space (14), with a second lock door (8) and
- a second primary door lock (7) which connects the primary treatment chamber (3) to the aftertreatment chamber (4) vacuum-tight, the aftertreatment module (11) being switchable as a lock for the unloading of the substrates from the primary treatment chamber (3).

2. The device as claimed in one of the preceding claims, wherein the primary lock doors (6, 7) are constituted as transfer valves inserted in a sealing manner especially in a common channel between the respectively adjacent chambers (2, 3, 4).

3. The device as claimed in one of the preceding claims, wherein there is a loading and unloading apparatus, especially at least one robot arm (16, 17) for loading and unloading of the substrates into/out of the primary treatment chamber (3) and/or the pretreatment chamber (2) and/or the aftertreatment chamber (4).

4. The device as claimed in one of the preceding claims, wherein the primary treatment chamber (3) can be loaded at the same time from the pretreatment chamber (2) and can be unloaded into the aftertreatment chamber (4) and/or the pretreatment chamber (2) and the aftertreatment chamber (4) can be loaded at the same time via the first lock door (5) and unloaded via the second lock door (8).

## Revendications

1. Dispositif de liaison de paires de substrats comprenant
- un premier module de pré-traitement pour le pré-traitement d'un premier substrat d'une paire de substrats comprenant une chambre de pré-traitement (2) pouvant être alimentée en vide, entourant un espace de pré-traitement (12), comprenant une première porte de vanne (5), dans lequel le premier module de pré-traitement est prévu pour un pré-traitement du premier substrat de la paire de substrats et un second module de pré-traitement est prévu pour un pré-traitement d'un second substrat de la paire de substrats,
- au moins un module de traitement principal (10) comprenant une chambre de traitement principal (3) pouvant être alimentée en vide, séparée de la chambre de pré-traitement (2), entourant un espace de traitement principal (13), dans laquelle la paire de substrats peut être amenée en contact et liée tandis que le premier module de pré-traitement peut parallèlement être chargé avec un autre substrat d'une paire de substrats,
- une première porte de vanne principale (6) reliant la chambre de pré-traitement (2) à la chambre de traitement principal (3) en étanchéité au vide, dans lequel le premier module de pré-traitement peut être raccordé en tant que vanne pour le chargement de la chambre de traitement principal (3) en substrats, et dans lequel le premier et le second substrats peuvent être chargés dans la chambre de traitement principal (3) par des portes de vanne séparées,
- au moins un module de post-traitement (11) comprenant une chambre de post-traitement (4) alimentée en vide, séparée de la chambre de traitement principal (3), entourant un espace de post-traitement (14), comprenant une seconde porte de vanne (8) et
- une seconde porte de vanne principale (7) reliant en étanchéité au vide la chambre de traitement principal (3) à la chambre de post-traitement (4), dans lequel le module de post-traitement (11) peut être raccordé en tant que vanne pour le déchargement des substrats de la chambre de traitement principal (3).

2. Dispositif selon l'une des revendications précédentes, dans lequel les portes de vanne principale (6, 7) sont conçues en tant que soupapes de transfert employées en étant étanches, en particulier dans un canal commun entre les chambres (2, 3, 4) respectives voisines.

3. Dispositif selon l'une des revendications précédentes, dans lequel un dispositif de chargement et déchargement, en particulier au moins un bras de robot (16, 17), est prévu pour charger et décharger les substrats dans la, et hors de la, chambre de traitement principal (3) et/ou chambre de pré-traitement (2) et/ou chambre de post-traitement (4).

4. Dispositif selon l'une des revendications précédentes, dans lequel la chambre de traitement principal (3) peut être parallèlement chargée par la chambre de pré-traitement (2) et déchargée dans la chambre de post-traitement (4) et/ou la chambre de pré-traitement (2) et la chambre de post-traitement (4) peuvent parallèlement être chargées par la première porte de vanne (5) et déchargées par la seconde porte de vanne (8).
